# EUROPEAN PATENT APPLICATION

(11) **EP 4 764 512 A1**
(43) Date of publication of application: **24.06.2026**
(21) Application number: 25194252.0
(22) Date of filing: 06.08.2025
(51) Int. Cl.: G01R 29/08, G01R 35/00

(54) **SYSTEM FOR SENSING AN RF SIGNAL**

(30) Priority: 18.12.2024 US 202418985919
(71) Applicant: Rohde & Schwarz GmbH & Co. KG, 81671 München (DE)
(72) Inventor: Ruster, Thomas, 81543 Munich (DE); Cardalda-Garcia, Adrian, 85551 Kirchheim bei München (DE); Ho, Melvyn, 81677 Munich (DE)
(74) Representative: Rupp, Christian

(57) **Abstract**

The present disclosure relates to a system (10) for sensing a radio frequency, RF, signal. The system (10) comprises a quantum sensor (11) comprising: a sensing element (12) which is arranged for being exposed to the RF signal, and a readout device (13) configured to detect a response of the sensing element (12) to the RF signal. The system (10) further comprises at least one RF sensor (14) which comprises an RF antenna and/or an RF port configured to receive the RF signal; and an evaluation module (15) configured to receive information on the RF signal from the quantum sensor (11) and from the at least one RF sensor (14), and to determine at least one characteristic of the RF signal based on said information.

## Description

### Technical Field

The present disclosure relates to a system for sensing radio frequency (RF) signals which combines the advantages of conventional RF sensors and quantum sensors.

### Background Art

Conventional measurement systems for RF signals, such as a spectrum analyzers, have one or several input channels as well as internal electronics to analyze the signal(s). For instance, an antenna is connected to an input channel in order to analyze an RF signal which is received by the antenna. However, such conventional measurement devices can only sense RF signals in a limited frequency bandwidth (e.g., up to 100 GHz or less). Furthermore, these sensors typically have a limited measurement accuracy and can perturb the signals to be measured in an unwanted way.

Quantum sensors are a new type of sensor which overcome many of these drawbacks and disadvantages. Quantum sensors can be highly accurate and can sense RF signals over a very broad frequency range, including high frequencies not accessible to conventional sensors (e.g., in the THz range). However, quantum sensor systems are usually complex and expensive. Also, sensitivity and instantaneous bandwidth may be inferior to traditional sensors.

Accordingly, there is a need to provide a system for sensing RF signals which overcomes the above mentioned disadvantages and limitations. In particular, there is a need to provide a sensor system which combines the advantages of conventional sensors and quantum sensors in a cost efficient way.

### Summary

The present disclosure provides a system for sensing a radio frequency (RF) signal. The system comprises a quantum sensor comprising a sensing element which is arranged for being exposed to the RF signal, and a readout device configured to detect a response of the sensing element to the RF signal. The system further comprises at least one RF sensor which comprises an RF antenna and/or an RF port configured to receive the RF signal; and an evaluation module configured to receive information on the RF signal from the quantum sensor and from the at least one RF sensor, and to determine at least one characteristic of the RF signal based on said information.

This achieves the advantage of providing a sensor system which combines the advantages of conventional, e.g. antenna-based, RF sensors and quantum sensors. Thereby, both technologies can be integrated in a cost-efficient manner, because common components, which are used for the evaluation of the respective sensor outputs, can be shared by both sensors.

The evaluation module can be a test and/or measurement device, such as an oscilloscope or spectrum analyzer, or can be integrated in such a test and/or measurement device. The quantum sensor (in particular the readout device) and the RF sensor can be connected to respective input ports of the test and/or measurement device.

For instance, the sensing element comprises a quantum system. The quantum system can be formed by an atomic gas of, e.g., Rydberg atoms. Alternatively, the quantum system can be formed by diamond material with NV (nitrogen vacancy center) defects.

The sensing element can be irradiated by the RF signal. The RF signal can thereby create an observable change in the quantum system. For instance, the readout device detects said change (e.g., a change in an emission spectrum) and forwards information derived from said change to the evaluation module.

The information on the RF signal can be forwarded from the readout device and/or the RF sensor to the evaluation module in the form of a digital signal or an analog signal which is digitalized by an ADC of the evaluation module.

The characteristic of the RF signal can be an amplitude and/or a spectrum of the RF signal.

In an implementation form, the evaluation module is configured to synchronize the quantum sensor and the RF sensor. The synchronization can be based on the received information from both sensors.

The evaluation module can further trigger a measurement with the quantum sensor and/or the RF sensor (or with both).

In an implementation form, the evaluation module is configured to calibrate the RF sensor based on information received from the quantum sensor, or vice versa. This achieves the advantage that the RF sensor can be calibrated by the output of the quantum sensor at frequencies for which there are no conventional calibration standards.

In an implementation form, the quantum sensor is configured to provide information on the RF signal at frequencies which are out of range of the at least one RF sensor. In this way, the quantum sensor can "extend" the frequency range of the RF sensor.

In an implementation form, the system further comprises a user interface (UI) which is configured to output the information provided by the quantum sensor and the at least one RF sensor.

In an implementation form, the RF sensor further comprises any combination of the following components: a mixer, a local oscillator, a filter, an equalizer, and a numerically controlled oscillator.

In an implementation form, the evaluation module is configured to evaluate if the information provided by the quantum sensor or the information provided by the RF sensor is more accurate for a particular measurement task.

In an implementation form, the system comprises one or more sensor heads which are directly or indirectly connected to the evaluation module. The sensor heads can be probe heads, i.e., the heads of a measurement probe.

In an implementation form, the sensing element and the at least one RF sensor are arranged in the same sensor head.

For example, the sensing element (with readout device) and the RF sensor are connected to a combined input of the evaluation module, e.g. sequentially or via a splitter, in order to operate as parallel systems.

In an implementation form, the sensing element and the RF sensor are arranged in separate sensor heads.

In an implementation form, the readout device comprises a light source configured to irradiate the sensing element with a light beam, and an optical detector configured to detect an optical response of the sensing element.

The sensing element or more specifically a sensing volume in the sensing element can be optically excited by the light beam. In response, the sensing element can emit radiation which can be detected by the optical detector. Information on the RF signal can be deducted from the characteristics of the emitted radiation.

In an implementation form, the readout device is arranged in a frontend or on an extension board of the system; wherein the frontend or the extension board are directly or indirectly connected to the evaluation module.

In an implementation form, the evaluation module comprises a digital signal processor (DSP) and/or a host processor which are configured to receive the information on the RF signal from the quantum sensor and from the at least one RF sensor.

### Brief Description of the Drawings

Exemplary embodiments of the disclosure are now further explained with respect to the drawings by way of example only, and not for limitation. In the drawings:
Fig. 1 shows a schematic diagram of a system for sensing an RF signal according to an embodiment; and
Fig. 2 shows a schematic diagram of a system for sensing an RF signal according to an embodiment.

### Detailed Descriptions of Embodiments

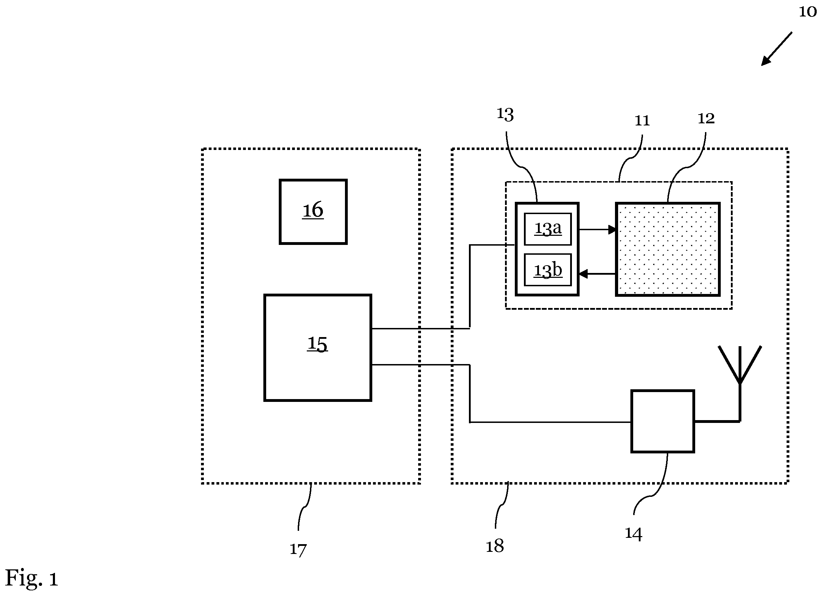

Fig. 1 shows a schematic diagram of a system 10 for sensing an RF signal according to an embodiment.

The system 10 comprises a quantum sensor 11 comprising a sensing element 12 which is arranged for being exposed to the RF signal and a readout device 13 configured to detect a response of the sensing element 12 to the RF signal. The system 10 further comprises at least one RF sensor 14 which comprises an RF antenna and/or an RF port configured to receive the RF signal; and an evaluation module 15 configured to receive information on the RF signal from the quantum sensor 11 and from the at least one RF sensor 14, and to determine at least one characteristic of the RF signal based on said information.

The sensing element 12 of the quantum sensor 11 may comprise a number of atoms or components behaving as atoms forming a quantum system. The sensing element 12 can be formed by or can comprise a sensing volume containing said atoms or atom-like components.

For example, the sensing element 12 comprises a quantum gas which is stored in a vapor cell. The atoms forming the quantum gas can be Rydberg atoms. Alternatively, the sensing element 12 can comprise a solid material, e.g. diamond, which comprises a number (micro)components behaving as atoms. For instance, the diamond is an NV diamond, i.e., a diamond with NV (nitrogen vacancy center) defects.

The readout device 13 may comprise a light source 13a (e.g., a laser) configured to irradiate the sensing element 12 with a light beam and an optical detector 13b (e.g., a photo diode or camera) configured to detect an optical response of the sensing element 12. Optionally, the readout device 13 may comprise at least one field generator configure to generate an electric, a magnetic and/or an electromagnetic control field within the sensing element.

The readout device 13 may comprise electronics to evaluate the readings of the detector 13b, such as an ADC and an FPGA to evaluate the ADC readings. The readout device 13 may comprise further means for an electrical read-out of the sensing element 12, e.g. special amplifiers for the Rydberg cells and/or current amplifiers.

The quantum system in the sensing element 12 can be adapted by the light beam and, optionally, by the additional control fields (e.g., an RF or magnetic field). For example, the atoms or the atom-like components in the sensing element 12 are optically excited from a ground state to an excited state by the light beam. Furthermore, a characteristic of the quantum system, e.g. a resonant frequency of the excited atoms or components, can be adapted by changing a parameter of the light beam and/or the control fields.

For sensing the RF signal, the sensing element 12 can be irradiated by the RF signal and the readout device 13 can read-out a response of the sensing element 12 to the RF signal. For example, the RF signal interacts with the sensing element 12 (e.g., the excited Rydberg atoms), wherein this interaction is indicative of a characteristic of the RF signal. The characteristics could be an amplitude of the signal. For instance, if the RF signal is resonant (or near-resonant) to two energy levels in the quantum system formed by the Rydberg atoms, it can change the state of the quantum system. This can be read out by optical means, e.g., by the optical detector 13b that detects an optical change in the sensing element 12 due to the interaction.

The at least one RF sensor 14 can be an antenna-based sensor. For instance, the RF sensor 14 comprises one or more Rx antennas which are optimized for a certain frequency range of the RF signal. In addition or alternatively, the RF sensor 14 may comprise one or more ports for connecting antennas or for directly connecting a DUT that emits the RF signal. The RF sensor 14 can receive the RF signal via the port.

The RF sensor 14 may further comprise a mixer, a local oscillator, a filter, an equalizer, and/or a numerically controlled oscillator. The RF sensor 14 can be configured to adapt and/or pre-process a received RF signal with these components and forward the thus adapted signal (or parts thereof) to the evaluation module.

The RF signal can comprise signal components in the MHz, GHz and/or THz range. For instance, the RF signal is a microwave signal or a 4G or 5G telecommunication signal.

The evaluation module 15 can be a test and/or measurement device, such as an oscilloscope or spectrum analyzer, or can be integrated in such a test and/or measurement device. The quantum sensor 11 (in particular the readout device 13) and the RF sensor 14 can be connected to respective inputs of the test and/or measurement device.

The evaluation module 15 can process the output of the quantum sensor 11 and the RF sensor 14 and, as a result, determine one or more characteristics of the RF signal. The characteristic(s) of the RF signal can comprise an amplitude and/or a spectrum of the RF signal. The information on the RF signal can be forwarded from the readout device 13 (and/or from the RF sensor 14) to the evaluation module 15 in the form of a digital signal or an analog signal which is digitalized by the evaluation module 15.

The evaluation module 15 can comprise a processor (e.g., a microprocessor) for processing the output of the sensors 11, 14. The evaluation module 15 may further comprise any combination of the following components: an analog-to-digital converter, a field programmable gate array, a digital signal processor, a Fast Fourier transformation unit, a switch, a combiner, a multiplexer, and multiple inputs.

The evaluation module 15 can comprise any components suitable for reading out the RF sensor 14 and the quantum sensor 11. In this way, both sensor technologies can be combined in a cost-efficient manner as shared components do not have to be present twice.

Furthermore, both sensors 11, 14 can complement each other and together form a sensor system 10 that operates over a wide frequency range and with a high accuracy. In addition, the quantum sensor 12 can add several advantages to the antenna based sensor 14, such as improved measurement accuracy, a purely dielectric sensor head that does not perturb a microwave field to be measured, and a very broad frequency range. The evaluation module 15 can carry out conventional analysis techniques, such as vector signal analysis tasks, based on the output of each sensor 11, 14.

For example, the evaluation module 15 is further configured to synchronize the quantum sensor 11 and the RF sensor 14. The synchronization can be based on the received information from both sensors 11, 14. The evaluation module 15 can further trigger a measurement with the quantum sensor 11 or the RF sensor 14 (or with both).

Tasks requiring both sensors 12, 14 may be synchronized by the evaluation module 15.

The evaluation module 15 may have control over the RF sensor 14. E.g. the evaluation module 15 may further be configured to calibrate the RF sensor 14 based on information received from the quantum sensor 11, or vice versa. Thereby it can be utilized that the quantum sensor can deliver accurate measurements even at very high frequencies for which there is no conventional calibration standard. In particular, a quantum system offers good tractability of absolute power of an EM filed over a wide frequency range, which can be utilized when calibrating the RF sensor 14.

The quantum sensor 11 may further be configured to provide information on the RF signal 11 at frequencies which are out of range of the RF sensor 14. In this way, the quantum sensor 11 can extend the working range of a test and/or measurement system with an antenna based RF sensor 14 (e.g., a spectrum analyzer, oscilloscope or other receiver).

The system 10 may comprise an optional user interface (UI) 16. The UI 16 can be configured to output information provided by the quantum sensor 11 and the at least one RF sensor 14 and/or parameters determined based on said information. The UI 16 can be a unified UI to analyze the outputs of the two sensor types.

For example, the evaluation module 15 further evaluates which of the sensors 11, 14 provides a more accurate measurement for a particular measurement task, i.e., if the information provided by the quantum sensor 11 or the information provided by the RF sensor 14 is more accurate for the measurement task. This evaluation can be implemented via a software control.

The evaluation module 15 may then discard the information provided by the respective sensor 11, 14 which is considered less accurate. For instance, when analyzing an RF signal at a very high frequencies (e.g. in the THz range), the evaluation module 15 may only consider the output of the quantum sensor 11 and discard the output of the RF sensor 14, as only the quantum sensor 11 is considered accurate in at these frequencies.

The system 10 can comprise at least one sensor head 18 which is directly or indirectly connected to the evaluation module 15. For instance, the at least one sensor head 18 is connected to a test and/or measurement device 17 which comprises (or is identical to) the evaluation module 15. The sensor head 18 can be a probe head, i.e., the head of a measurement probe.

The sensing element 12 of the quantum sensor 11 and the at least one RF sensor 14 can be arranged in a single, shared sensor head 18. The readout device 13 can also be arranged in this sensor head 18, as shown in Fig. 1, or external to the sensor head.

Alternatively, the system 10 can comprise an extension module, e.g. in the form of a fronted or an extension board or card (not shown in Fig. 1). The extension module may carry at least some quantum sensor 11 specific components, in particular the components of the readout device 13 (e.g., lasers and photodiodes). The extension module can be electrically connected to the shared components of the system, i.e., the evaluation module 15 and its components (e.g., an ADC, a FPGA, and a CPU).

In case the extensions module is a frontend, it can be a separate device which is connected to the test and/or measurement system comprising the evaluation module 15 via a cable. In case the extensions module is an extension board or card, it could be inserted into the test and/or measurement device (e.g., plugged into a suitable connector within the test and/or measurement device).

The extension module can have an input connector that is suitable for connecting the probe head 18 which comprises the quantum sensor 11, e.g., via an optical fiber.

For example, the sensing element 11 (with readout device 13) and the RF sensor 14 are connected to a combined input of the evaluation module 15, e.g. sequentially or via a splitter, in order to operate as parallel systems. If both sensors 11, 14 are connected to the input of the evaluation module 15 (or a test and/or measurement device comprising the module 15) sequentially, the quantum sensor 11 may be connected first.

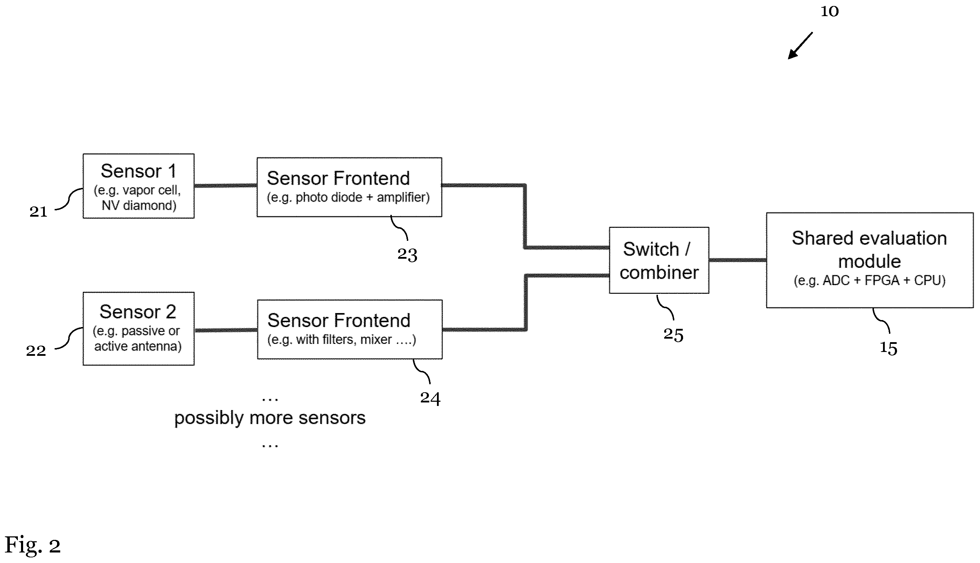

Fig. 2 shows a schematic diagram of the system 10 according to a further embodiment.

In the example shown in Fig. 2, the sensing element (in Fig. 2: sensor 1) and the RF sensor (in Fig. 2: sensor 2) are arranged in separate sensor heads 21, 22. These separate sensor heads 21, 22 can be connected to the (shared) evaluation module 15 via a switch and/or combiner unit 25.

The exemplary system 10 further comprise at least two frontends 23, 24. For instance, each probe head 21, 22 is connected to one of the frontends 23, 24. The frontends can comprise components for reading-out and/or controlling the respective sensors 11, 14. For example, the readout device 13 (e.g., a light source 13a, an amplifier and/or an optical detector 13b) are arranged on a first frontend 23 and/or components for reading out the RF sensor 14 (e.g., filters, mixers) are arranged on a second frontend 24.

Instead of frontend(s), which are e.g. directly or indirectly connected to the evaluation module 15, the system 10 may comprise one or more extension boards or cards which comprise the components for reading-out and/or controlling at least one of the sensors 11, 14. The extension boards or cards can be inserted in a test and/or measurement device that comprises the evaluation module 15 as explained above.

The frontend functionality may be provided by 15 - either by extension boards or fully integrated.

The evaluation module 15 may further comprise a digital signal processor (DSP) and/or a host processor which are configured to receive the information on the RF signal from the quantum sensor 11 and from the at least one RF sensor 14.

In summary, the architecture of the system 10 allows to combine antenna based RF measurements with quantum-enhanced measurements in a cost-effective way, as common components can be shared between these two sensors. This approach is not only applicable for over-the-air measurements, but could be used for conductive measurements as well. Since the sensing element 12 of the quantum sensor 11 typically comprises only non-conductive materials and, thus, does not consume a microwave (or other RF) field to be measured, it could also be integrated into the input port of a conventional RF sensor.

While various embodiments of the present disclosure have been described above, it should be understood that they have been presented by way of example only, and not limitation. Numerous changes to the disclosed embodiments can be made in accordance with the disclosure herein, without departing from the spirit or scope of the disclosure. Thus, the breadth and scope of the present disclosure should not be limited by any of the above-described embodiments. Rather, the scope of the disclosure should be defined in accordance with the following claims and their equivalents.

Although the disclosed embodiments have been illustrated and described with respect to one or more implementations, equivalent alterations and modifications will occur or be known to others skilled in the art upon the reading and understanding of this specification and the annexed drawings. In addition, while a particular feature of the present disclosure may have been disclosed with respect to only one of several implementations, such feature may be combined with one or more other features of the other implementations as may be desired and advantageous for any given or particular application.

## Claims

1. A system (10) for sensing a radio frequency, RF, signal, comprising:
a quantum sensor (11) comprising:
- a sensing element (12) which is arranged for being exposed to the RF signal, and
- a readout device (13) configured to detect a response of the sensing element (12) to the RF signal;
at least one RF sensor (14) which comprises an RF antenna and/or an RF port configured to receive the RF signal; and
an evaluation module (15) configured to receive information on the RF signal from the quantum sensor (11) and from the at least one RF sensor (14), and to determine at least one characteristic of the RF signal based on said information.

2. The system (10) of claim 1,
wherein the evaluation module (15) is configured to synchronize the quantum sensor (11) and the RF sensor (14).

3. The system (10) of claim 1 or 2,
wherein the evaluation module (15) is configured to calibrate the RF sensor (14) based on information received from the quantum sensor (11), or vice versa.

4. The system (10) of any of the preceding claims,
wherein the quantum sensor (11) is configured to provide information on the RF signal at frequencies which are out of range of the at least one RF sensor (14).

5. The system (10) of any of the preceding claims, further comprising:
a user interface (16), UI, which is configured to output the information provided by the quantum sensor (11) and the at least one RF sensor (14).

6. The system (10) of any of the preceding claims,
wherein the RF sensor (14) further comprises any combination of the following components: a mixer, a local oscillator, a filter, an equalizer, and a numerically controlled oscillator.

7. The system (10) of any of the preceding claims,
wherein the evaluation module (15) is configured to evaluate if the information provided by the quantum sensor (11) or the information provided by the RF sensor (14) is more accurate for a particular measurement task.

8. The system (10) of any of the preceding claims, comprising:
one or more sensor heads which are directly or indirectly connected to the evaluation module (15).

9. The system (10) of claim 8,
wherein the sensing element (12) and the at least one RF sensor (14) are arranged in the same sensor head.

10. The system (10) of claim 8, comprising:
wherein the sensing element (12) and the RF sensor (14) are arranged in separate sensor heads.

11. The system (10) of any of the preceding claims,
wherein the readout device (13) comprises:
- a light source configured to irradiate the sensing element (12) with a light beam, and
- an optical detector configured to detect an optical response of the sensing element (12).

12. The system (10) of any of the preceding claims,
wherein the readout device (13) is arranged in a frontend or on an extension board of the system (10);
wherein the frontend or the extension board are directly or indirectly connected to the evaluation module (15).

13. The system (10) of any of the preceding claims,
wherein the evaluation module (15) comprises a digital signal processor, DSP, and/or a host processor which are configured to receive the information on the RF signal from the quantum sensor (11) and from the at least one RF sensor (14).
